Europäisches Patentamt

**European Patent Office**

Office européen des brevets

(19)

(11) Publication number: **0 008 175**
**B1**

# EUROPEAN PATENT SPECIFICATION

(12)

(45) Date of publication of patent specification: **25.08.82**

(51) Int. Cl.³: **G 01 N 27/56, B 22 F 7/04**

(21) Application number: **79301470.5**

(22) Date of filing: **24.07.79**

(54) Process for forming a dense thin sintered layer.

(30) Priority: **24.07.78 JP 89322/78**

(43) Date of publication of application:
**20.02.80 Bulletin 80/4**

(45) Publication of the grant of the patent:
**25.08.82 Bulletin 82/34**

(84) Designated Contracting States:
**DE FR GB**

(56) References cited:
**DE - A - 2 742 278**
**DE - A - 2 746 381**
**US - A - 2 987 423**
**US - A - 3 754 968**

(73) Proprietor: **NISSAN MOTOR COMPANY, LIMITED**
**No.2, Takara-cho, Kanagawa-ku**
**Yokohama-shi Kanagawa-ken 221 (JP)**

(72) Inventor: **Ikezawa, Kenji**
**No. 714 Nishiterao. Kanagawa-ku**
**Yokohama City (JP)**
Inventor: **Takao, Hiroshi**
**No. 1471, Kajiwara**
**Kamakura City (JP)**
Inventor: **Aoki, Hiroyuki**
**No. 621, Noba-machi, Konan-ku**
**Yokohama City (JP)**
Inventor: **Kimura, Shinji**
**No. 714 Nishiterao, Kanagawa-ku**
**Yokohama City (JP)**

(74) Representative: **Lamb, John Baxter Marks & Clerk**
**et al,**
**57/60 Lincoln's Inn Fields**
**London WC2A 3LS (GB)**

Courier Press, Leamington Spa, England.

Process for forming a dense thin sintered layer.

This invention relates to a process for forming a dense thin sintered layer upon a substrate, and more particularly to an improved process for forming a dense thin sintered layer upon a substrate using a screen printing technique from a paste comprising a powdered material, such as an oxygen ion-conductive solid electrolyte, alumina or glass insulator or a conductive metal, dispersed in an organic vehicle.

It is an object of the present invention to provide a process for forming a thin sintered layer upon a substrate which is more dense than one obtained by known methods employing a screen printing technique.

It is another object of the present invention to provide an improved process employing a screen printing technique which can yield a satisfactorily thin dense sintered layer upon a substrate without involving any severe controls of operating conditions such as paste viscosity, powder/vehicle ratio, printing and drying conditions such as may be required in the prior art methods employing a screen printing technique.

It is a further object of the present invention to provide a process as mentioned above, which can yield a thin dense sintered layer from paste compositions which layer has a longer life and is more stable in quality, than those obtained by known methods employing a screen printing technique.

In the following description reference will be made to the accompanying drawings in which:

Figure 1 is a schematic sectional view of a typical oxygen sensor using a thin layer of solid electrolyte;

Figure 2 is a graphical representation of the water absorption of different types of solid electrolyte layers;

Figure 3 is a graphical representation of the specific resistance of the solid electrolyte layers; and

Figure 4 is a graphical representation of the output characteristics of oxygen sensors.

The screen printing process is a well known technique used in forming thin layers using paste compositions. The screen printing process is used in various fields and is particularly widely used in the electronic or electrical industries. In methods employing the screen printing process, a paste comprising a powder of the desired material dispersed in an organic vehicle is first provided and is then printed onto a substrate by the screen printing technique, dried at a suitable temperature and finally sintered at elevated temperature to form a thin sintered layer on the substrate.

The application of a wear-resistant layer to an alloy substrate by the steps of applying a layer of a slurry comprising an organic binder and nickel, chromium, boron, silicon and titanium carbide to the substrate, drying it and sintering it and then applying a second layer of a slurry containing an organic vehicle and nickel, chromium, boron and silicon to the substrate, drying it and sintering it, is disclosed in US—A—3754968.

The formation of thin solid layers is required in various other industries including the automobile industry. For example, much attention has been recently directed in the automobile industry to oxygen sensors. Oxygen sensors make use of an oxygen ion conductive solid electrolyte layer, which is preferably as thin and dense as possible for reasons which will be discussed in detail hereinafter.

Solid electrolyte layers have heretofore been formed by several methods including plasma spray coating and high frequency sputtering. However, these methods do not satisfactorily provide a thin dense layer of the electrolyte. There has been proposed in Japanese Patent Application No. 53—58280 a paste composition comprising an oxygen ion-conductive solid electrolyte dispersed in an organic vehicle which is particularly adapted for use with the screen printing technique.

As is well known, the electromotive force of an oxygen concentration cell, or an oxygen sensor constructed on the basis of the principle of such a cell, decreases with an increase of the internal resistance of the cell or sensor. In order to produce as high and as stable an electromotive force as possible, it is necessary to reduce the internal resistance of the cell or sensor to a minimum. The internal resistance of the cell or sensor is substantially dependent on the resistance of the solid electrolyte used.

The resistivity of a solid electrolyte is expressed as a function of the absolute temperature and exponentially decreases with increasing temperature. Assuming that a solid electrolyte is used as an oxygen sensor for controlling the air-fuel ratio of a combustion system, such as of an automobile engine, the output potential from the sensor should be at a level required for controlling the combustion system at temperatures above about 300°C. In order to control the air-fuel ratio at the time of cold start, the sensor must normally operate even at temperatures as low as one hundred and several tens of degrees centigrade. To satisfy the above requirements by the use of existing solid electrolytes, the sensor must be of a specific type. That is, the solid electrolyte layer of the sensor should be made very thin so that the internal resistance of the sensor itself becomes small, permitting the loss of the electromotive force due to the internal resistance to be reduced to a minimum. This presents advantages in that the electromotive force increases because of the reduction of the internal loss and in that the response speed of the sensor is improved.

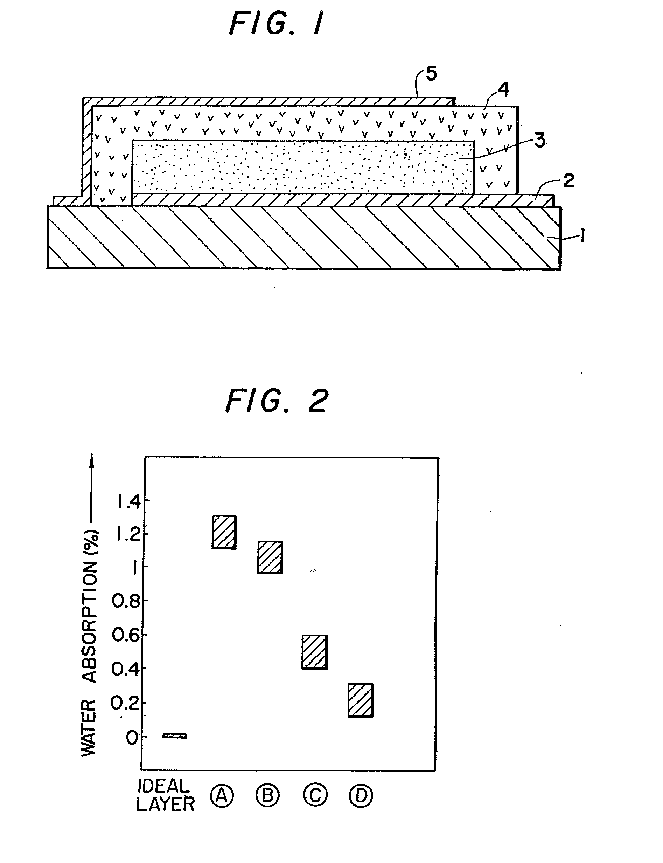

The above is more particularly illustrated by an oxygen sensor for air-fuel ratio control using a thin or superposed layer of an oxygen ion-conductive solid electrolyte. Such a sensor is schematically shown in Figure 1, and comprises an alumina insulating substrate 1, having a platinum electrode 2 vacuum-deposited therein. A reference oxygen partial pressure producing Ni—NiO electrode 3 is vacuum-deposited on the platinum electrode 2, with a solid electrolyte layer 4, obtained by printing a solid electrolyte paste composition by a screen printing method, and sintering the applied paste, surrounding electrode 3 and sintering the applied paste. A platinum electrode 5 is vacuum-deposited on the solid electrolyte layer 4.

The theoretical electromotive force of the oxygen sensor shown in Figure 1 is represented by the following equation using the ratio of oxygen partial pressures at opposite sides of the solid electrolyte layer 4:

$$E = \frac{RT}{4F} \ln \frac{PO_2}{PO'_2}$$

in which R represents a gas constant, F is a Faraday's constant, T represents the absolute temperature, $PO_2$ represents the reference oxygen partial pressure which is determined from the equilibrium oxygen partial pressure between the metal and the metal oxide, i.e. Ni—NiO, to be the reference oxygen partial pressure generating substance in the form of a layer which is provided on the inner side of the electrolyte layer 4, and $PO'_2$ represents the oxygen partial pressure in the exhaust gas at the outer side of the solid electrolyte layer 4.

It has been confirmed experimentally that the solid electrolyte layer should meet the following requirements in order to permit the oxygen sensor to operate in a stable manner.

(1) The layer should be so dense as not to allow gas permeation therethrough.

(2) The layer should be stable in composition without undergoing any significant change after a lapse of time.

(3) The layer should have high conductivity.

Of these, the requirement (1), namely that the layer be dense and pass no gas therethrough is most important. If an exterior atmospheric gas readily passes through the solid electrolyte layer, the electromotive force E becomes zero. Even if the gas permeation through the layer is very small, the output potential E from the sensor will gradually decrease as the sensor is used for a long time and finally comes to zero.

Accordingly, careful attention should be paid to the formation of the thin solid layer so that the layer is so dense as to permit no gas permeation. However, it has been experimentally found that the yield of a gas-permeation-free, dense layers of solid electrolyte by known processes employing screen printing methods is as low as about 50% mainly due to great variations in a number of operating factors which will be inevitably involved during the course of fabrication of the sensor.

Typical factors which will adversely affect the denseness of the layer are:

(1) Inhomogeneous dispersion of powder in the paste.

(2) Changes in properties of the paste, e.g. viscosity and power/vehicle ratio, with the lapse of time.

(3) Variations in printing thickness and other printing conditions.

(4) Variation in drying conditions.

In order to form a dense layer, all the adversely affecting factors must be removed by closely controlling all the conditions relating to such factors. However, difficulties will be encountered in such close control of the conditions within the desired ranges so as to attain the denseness of the layer. Variations of such conditions to some extent will inevitably occur in industrial practice.

As described above, formation of a very thin dense solid electrolyte by the prior art method involving a screen printing technique involves severe restrictions, for example in preparation and storage of the paste, printing and drying conditions and the like, resulting in a lower productivity.

According to the present invention, there is provided a process for forming a thin dense sintered layer on a substrate comprising:

(a) one or more preliminary coating operations comprising the steps of applying a paste, comprising a sinterable material in powder form dispersed in an organic vehicle, to the substrate by a screen printing technique, and drying and calcining or sintering the coated paste; and

(b) a final coating operation comprising the steps of applying a paste, comprising the sinterable material in powder form dispersed in an organic vehicle, to the coated substrate by a screen printing technique and drying and sintering the coated paste under sintering conditions;

characterised in that the calcination or sintering temperature in the preliminary coating operation(s) is from 0.4 to 0.8 times the sintering temperature in the final coating operation and that the powder employed in the final coating operation has a particle size not more than 0.9 times that of the powder employed in the preliminary coating operation(s).

Thus, as will be appreciated, in the process of the invention there will be an initial application of a coating layer to the substrate and a final application of a coating to the substrate with, possibly, one or more intermediate applications of coatings to the substrate.

3

The calcination or sintering in the preliminary, i.e. the first and any intermediate, coating operation(s) is carried out at a temperature of from 0.4—0.8 times the sintering temperature in the final coating operation, which may vary depending on the type of paste.

Also, the powder in the paste applied in the final coating operation has an average size of less than 0.9 times the average size of the powder used in the intermediate coating operation(s).

As described above the coating operation comprising the series of steps of paste coating, drying and calcination or sintering steps is repeated at least two times. Assuming that the coating operation is repeated $x$ times, the layer obtained after completion of the $(x-1)$th sintering step may still contain imperfections or pores which permit possible gas permeation as discussed hereinbefore. In order to remove the imperfections, the $x$th paste coating is carried out so as to allow the powder in the paste to be charged into the imperfections (or pores) present in the layer by the use of the fluidity of the paste. Needless to say, gas permeation takes place because of the presence of open pores in the layer. These open pores are almost completely charged and filled with powder in the final coating operation.

In order to improve the denseness of the layer, it has been experimentally found that each sintering up to the $(x-1)$th coating operation should be conducted at a temperature as low as 0.4—0.8 times the final sintering temperature. This is because the layer which has been calcined at such low temperature remains porous, which facilitates the powder in the paste to be more densely charged in the pores in the final ($x$th) coating operation due to the fluidity of the paste and to the absorptibility of the porous layer.

In view of the above fact, the powder of the paste used in the final ($x$th) coating operation has an average size smaller than the powder used prior to the final coating step. In general it is believed that the average size of the pores present in the calcined layer formed during the course of the coating operation up to and including $(x-1)$th coating operation is smaller than an average size of the powder due to its self-charging action and as a result of calcination. Accordingly, in order that the pores in the layer are satisfactorily charged with the powder in the final coating operation, the average size of the powder in the paste used in the final coating operation is smaller than that of the powder employed in the preliminary coating operation(s). Though the average size of the powder used in the final coating operation may more or less vary depending on the average size of the powder employed prior to the final operation and the calcining temperature, it has been experimentally confirmed that the average size of powder used in the final coating operation should not be greater than 0.9 times that of the powder used in the preliminary coating operations.

As mentioned hereinabove, the calcining or sintering temperature in the preliminary coating operation(s) is 0.4—0.8 times that of the sintering temperature in the final coating operation for the reason that a porous layer is purposely formed to allow fine powder to be readily charged in the pores in the final coating operation. When the calcination or sintering is carried out at temperatures outside the above-indicated range, e.g. at higher temperatures than those indicated, the coating layer becomes too dense, producing similar results to the case where a series of coating and sintering steps is simply repeated. On the other hand, if the calcination or sintering is conducted at temperatures lower than those in the defined range, the layer becomes satisfactorily porous but has low strength, imposing limitations on subsequent handling and coating operations, coupled with another disadvantage that the organic vehicle in the paste is not completely dissipated or decomposed and remains in the layer.

The process employed in the present application differs from the technique disclosed in US—A—3754968 in two important respects, namely that the first coating is intended at a temperature below that employed in the second operation and the particle size of particles in the final coating operation is less than that of those in the first coating.

The process of the present invention may be used to apply various types of solid powder-containing pastes to substrates. The application of a solid electrolyte paste will be particularly described.

As mentioned above, there has been proposed in Japanese Patent Application No. 53—58280 a solid electrolyte paste composition. Briefly, the paste composition comprises an oxygen ion-conductive solid electrolyte in the form of a powder and an organic vehicle having the powder dispersed therein, the powder and the vehicle being mixed in a weight ratio of 1:0.25—2.5. The powder should have an average size not greater than 0.7 microns, a maximum size not greater than 6.0 microns, and a specific surface area within a defined range. This paste composition is designed to be applied by a known screen printing method so as to form a thin dense solid electrolyte layer. The paste composition is applied onto an insulating substrate by a screen printing technique, dried at 100—200°C, and sintered at 800—1500°C to form a solid electrolyte layer.

According to the process of the invention, however, it is not necessary to powder the solid electrolyte so finely in order to give a dense thin layer in high yield. In the practice of the invention, the average size of the powder is generally from 0.2 to 12 microns, preferably from 0.5 to 8 microns. Such larger-sized powders will suffice to give a dense layer. With respect to the maximum size of the powder, it is necessary that the maximum size be 40 microns or less, because a paste containing the powder is printed or applied onto a substrate by a screen printing technique. Such size of powder can, in practice, be selected using a 400 mesh sieve.

When the powder used in the preliminary coating operation(s) has a size within the above-defined

**O 008 175**

range, the size of powder used in the final coating operation should be not greater than 0.9 times that of the initially employed powder.

Solid electrolytes useful in the invention are those which are known to the art and include, for example, $Y_2O_3$—$ZrO_2$, $CaO$—$ZrO_2$, $ThO_2$—$Y_2O_3$, $NbO_2$—$Bi_2O_3$, $CeO_2$—$La_2O_3$ and the like.

The organic vehicle is a mixture of a organic binder and a high boiling organic solvent and, if necessary, additives. The organic binder may, for example, be a cellulose derivative such as methyl cellulose or nitro-cellulose, ordinarily employed in various types of paste compositions to be applied by the known screen printing method. The high boiling solvent may, for example, be terpineol or cyclohexane. Plasticizers such as dibutyl phthalate or surfactants such as polyethylene glycol ether may be added as additives, if necessary.

The powder and the organic vehicle are mixed well in a mill such as a roller mill, a vibrating mill, a rotary ball mill or the like to give the paste.

The solid electrolyte paste suitable for the practice of the invention suitably has a solids content of 30% to 70% on the weight basis. The organic vehicle suitably comprises 2.0 wt.% to 15.0 wt.% of the binder, 45.0 wt.%, 80.0 wt.% of the high boiling solvent, 10 wt.% to 40 wt.% of the plasticizer, and 1.0 wt.% to 3.5 wt.% of the surfactant, all based on the weight of the vehicle.

The paste is readily prepared by mixing the powder and the organic vehicle in a mill such as a roller mill, a vibrating mill, a rotary ball mill or the like.

The solid electrolyte paste thus prepared is ready for application and when, for example, applied as an oxygen sensor illustrated in Figure 1, the paste is printed on the Ni—NiO layer formed on an insulating substrate such as alumina, dried and calcined or sintered, followed by repeating the above procedure at least one more time according to the process of the invention. The solid electrolyte layer after drying is sintered at 800°C to 1500°C.

When, for example, the final layer is sintered at about 1420°C, the sintering or calcination prior to the final coating and sintering operation is preferably conducted at a temperature from about 570°C to about 1140°C. As the calcining temperature increases, the layer becomes more dense, so that the thickness of the layer obtained after repetitions of the coating and calcining procedure at higher temperatures becomes greater than that obtained using lower calcination temperatures. In order to make the layer thickness as small as possible without changing the composition of paste and other operating conditions, it is preferred to use a calcining temperature on the lower side.

In a preferred aspect, the paste is applied onto a suitable substrate, dried and calcined at about 570°C to about 1140°C; this procedure is repeated; and then the final paste is applied onto the thus treated substrate, and dried and sintered at 800°C to 1500°C, preferably about 1420°C. In the best mode of the process of the invention using a solid electrolyte paste, a paste of a powder having an average size of 0.5 to 8 microns (and capable of passing through a 400 mesh sieve) is applied onto a suitable substrate, dried and calcined at about 570°C to about 1140°C; this above procedure is repeated once; and a paste using a powder of the same type but having an average size not greater than 0.9 times that of the firstly and secondly employed powder is applied onto the superposed layer, dried and sintered at about 1420°C.

Apart from solid electrolyte pastes, the process of the present invention is applicable to various types of solid powder-containing pastes ordinarily employed for the production of electronic components. For example, the process may be effectively used to form insulating layers from alumina or glass insulating pastes which are often applied during the course of fabrication of circuits such as integrated circuits for insulation of conductive portions thereof, ensuring formation of a very dense thin layer which is much more improved in dielectric strength, life, and quality as compared with those obtained by the known screen printing method.

Further, there can be applied by the process of the invention other known pastes ordinarily used in the electronic or electric industry and including, for example, insulating or circuit-protecting pastes comprising fine powders of borosilicate glasses or crystalline frit dispersed in an organic vehicle; dielectric pastes for capacitors comprising dielectric barium titanate powder dispersed in an organic vehicle; resistor pastes such as mixtures of ruthenium oxide and metal powder dispersed in an organic vehicle; and conductor pastes used to electrically interconnect two or more elements and containing powders of platinum or its alloys, gold or its alloys, silver or its alloys, or palladium alloys dispersed in an organic vehicle. In these pastes, similar organic vehicles as used for the solid electrolyte paste are employed. These known pastes need not necessarily be specifically formulated for application by the process of the invention except that the solid powder used in the paste in the final coating operation is smaller in average size as discussed above.

The number of repetitions of the coating-sintering or calcining procedure prior to the final coating-sintering procedure varies depending on the type of paste. It has been found that with the solid electrolyte paste, for example, when $x = 2$ or the total number of repetitions is two, the yield of product reaches 98%. When $x = 3$ for alumina insulating paste and $x = 2$ for glass paste, the yield of product reaches approximately 100% in each case. From the above, it is believed that only a few repetitions of the coating-sintering procedures are required.

It should be emphasised that though it may be considered that the process of the invention comprises mere repetition of known screen printing and sintering procedures, the process is very

5

advantageous from an industrial point of view in that a very dense layer is obtained and that such severe limitations in the preparation of powder and paste, viscosity of the paste, and drying and sintering conditions as will be experienced in known method employing screen printing techniques are not necessary.

In order that the invention may be well understood the following examples are given by way of illustration only.

## Example 1

Solid electrolyte pastes 1 and 2 having the formulations given below were prepared using solid electrolyte powders with different average particle sizes.

### Paste 1

| | |
|---|---|
| Powder: | $ZrO_2$ containing 8 wt.% $Y_2O_3$ |
| Average particle size: | about 7.2 microns (passed through a 400 mesh sieve) |

| Organic vehicle: | | |
|---|---|---|
| | ethyl cellulose | 6.8 wt.% |
| | teripineol | 60.0 wt.% |
| | dibutyl phthalate | 32.0 wt.% |
| | polyethylene glycol ester | 1.2 wt.% |

| | |
|---|---|
| Powder content of paste: | 50 wt.% |

### Paste 2

| | |
|---|---|
| Powder: | $ZrO_2$ containing 8 wt.% $Y_2O_3$ |
| Average particle size: | about 6 microns (passed through a 400 mesh sieve) |

| Organic vehicle: | | |
|---|---|---|
| | ethyl cellulose | 6.8 wt.% |
| | terpineol | 60.0 wt.% |
| | dibutyl phthalate | 32.0 wt.% |
| | polyethylene glycol ester | 1.2 wt.% |

| | |
|---|---|
| Powder content: | 50 wt.% |

The pastes were printed onto alumina substrates by a screen printing method and sintered under the conditions indicated below. The resulting solid electrolyte layers were assessed by measuring their water absorption and specific resistance. It is well known that the specific resistance increases with increased porosity and thus the denseness of layers can be evaluated by a comparison of their specific resistances.

Four procedures were followed (each procedure being repeated 20 times to give 20 samples for each procedure), namely known procedures A, B, and C and procedure D according to the present invention. The water absorption and specific resistance of the samples were measured, the measured values being averaged for the samples produced according to each procedure.

### Procedure A

The paste 1 was applied once to the substrate by screen printing, dried and sintered at 1420°C.

### Procedure B

The paste 2 was applied once to the substrate by screen printing, dried and sintered at 1420°C.

### Procedure C

The paste 1 was applied to the substrate by screen printing, dried and calcined at 1000°C, this procedure was repeated; and then the paste 1 was applied to the treated substrate, dried and sintered at 1420°C.

### Procedure D

The paste 1 was applied to the substrate by screen printing, dried and calcined at 1000°C; this procedure was repeated; and then paste 2 was applied onto the treated substrate, dried and sintered at 1420°C.

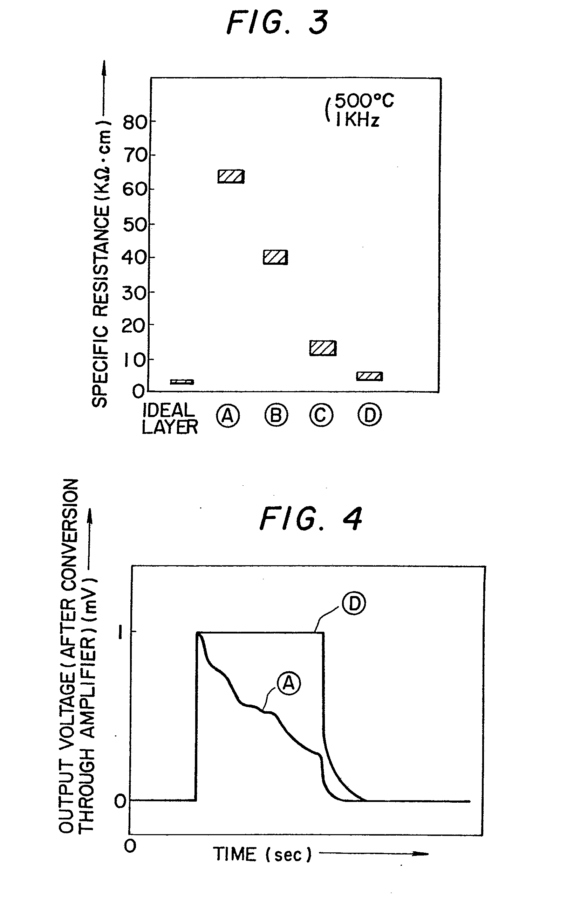

The results of the measurements for the samples of the respective types are shown in Figures 2 and 3 of the accompanying drawings showing the water absorption and specific resistance, respectively.

6

From the results, it will be appreciated that the process of the invention can markedly improve the water absorption and specific resistance properties, as compared with the known method.

Example 2

The oxygen sensor of the construction shown in Figure 1 of the drawings was made using a solid electrolyte layer formed according to the procedure D of Example 1 and its output characteristics were measured. For comparison, an oxygen sensor using a solid electrolyte layer formed by the procedure A of Example 1 was made and to determine its output characteristic similarly measured. The results are shown in Figure 4, from which it will be seen that the oxygen sensor using the solid electrolyte layer formed by the procedure D (according to the invention) is very stable in output voltage. On the other hand, the sensor using the electrolyte layer formed by the known procedure A has a considerably reduced output voltage and is thus unsuitable for use as a sensor for controlling the combustion system of automobile engines.

Example 3

Alumina insulating pastes 1 and 2 having the formulation given below were prepared using insulating powders with different average particle sizes.

Paste 1

| | |
|---|---|
| Powder: | $Al_2O_3$ |
| Average particle size: | 2.0 microns (maximum . . . 10.0 microns) |

| Organic vehicle: | | |
|---|---|---|
| | ethyl cellulose | 8.4 wt.% |
| | terpineol | 79.0 wt.% |
| | dibutyl phthalate | 10.0 wt.% |
| | polyethylene glycol ester | 1.6 wt.% |

| | |
|---|---|
| Powder content of paste: | 50 wt.% |

Paste 2

| | |
|---|---|
| Powder: | $Al_2O_3$ |
| Average particle size: | 1.6 microns (maximum . . . 10.0 microns) |

| Organic vehicle: | | |
|---|---|---|
| | ethyl cellulose | 8.4 wt.% |
| | terpineol | 79.0 wt.% |
| | dibutyl phthalate | 10.0 wt.% |
| | polyethylene glycol ester | 1.6 wt.% |

| | |
|---|---|
| Powder content of paste: | 50 wt.% |

Specimens were prepared using pastes 1 and 2 as follows.

A paste containing platinum was printed onto an alumina substrate and was then sintered at about 1200°C. The alumina insulating paste 1 was screen printed onto the sintered layer and was then calcined at about 910°C and this procedure was repeated once more.

Thereafter, the alumina insulating paste 2 was screen printed onto the formed layer of the paste 1 and then dried and sintered at about 1300°C. Finally, a paste containing platinum, was printed onto the thus formed layer of the paste 2 and then sintered at about 1200°C.

The specimens obtained by the above-mentioned method were assessed by measuring electrical insulation effect between the upper and lower platinum electrodes which were formed from the platinum-containing pastes. As a result, 192 out of 200 specimens exhibited good electrical insulation, without causing "shorts".

For reference, the electrical insulation effect was measured for specimens prepared by a conventional method in which the insulating layer was formed by only one sintering using the above-mentioned insulating paste 2. As a result, only about 60 to 70% of all the specimens exhibited good electrical insulation. It will be appreciated from such results, that the insulating layer formed according to the present invention is better as compared with that formed according to conventional methods.

While only alumina ($Al_2O_3$) has been described as used as the powder contained in the alumina insulating pastes 1 and 2 in Example 3, it will be appreciated that a mixture of alumina and silica ($SiO_2$) or magnesia (MgO) may be used as the insulating powder.

**0 008 175**

**Claims**

1. A process for forming a thin dense sintered layer on a substrate comprising:

(a) one or more preliminary coating operations comprising the steps of applying a paste, comprising a sinterable material in powder form dispersed in an organic vehicle, to the substrate by a screen printing technique, and drying and calcining or sintering the coated phase; and

(b) a final coating operation comprising the steps of applying a paste, comprising the sinterable material in powder form dispersed in an organic vehicle, to the coated substrate by a screen printing technique and drying and sintering the coated paste under sintering conditions; characterized in that the calcination or sintering temperature in the preliminary coating operation(s) is from 0.4 to 0.8 times the sintering temperature in the final coating operation and that the powder employed in the final coating operation has a particle size not more than 0.9 times that of the powder employed in the preliminary coating operation(s).

2. A process as claimed in claim 1 characterized in that the preliminary coating operation is carried out twice.

3. A process as claimed in claim 2 characterized in that the paste is a paste of an alumina insulating material.

4. A process as claimed in claim 2 characterized in that the paste is a glass paste.

5. A process for forming a layer of a solid, oxygen ion-conductive electrolyte upon an insulating substrate comprising:

(a) one or more preliminary coating operations comprising the steps of applying a paste, comprising a solid oxygen ion-conductive electrolyte in powder form dispersed in an organic vehicle, to the substrate by a screen printing technique, and drying out and calcining or sintering the coated paste; and

(b) a final coating operation comprising the steps of applying a paste, comprising the solid oxygen ion-conductive electrolyte in powdered form dispersed in an organic vehicle, to the coated substrate by a screen printing technique and drying and sintering the applied paste under sintering conditions; characterized in that the sintering in the final operation is carried out at a temperature of from 800 to 1500°C and the calcining or sintering in the preliminary coating operation(s) is carried out at a temperature from 0.4 to 0.8 times the sintering temperature in the final coating operation and the powdered solid electrolyte employed in the final coating operation has an average size not more than 0.9 times that of the powdered solid electrolyte employed in the preliminary coating operation(s).

6. A process as claimed in claim 5, in which the preliminary coating operation is carried out twice.

7. A process as claimed in claim 6, characterized in that the calcination or sintering in the preliminary coating operation is carried out at a temperature of from 570 to 1140°C and the sintering in the final coating operation is carried out at a temperature about 1420°C.

8. A process as claimed in any one of claims 5—7 characterized in that the powdered solid electrolyte has an average size of from 0.5 to 8 microns and a maximum size not exceeding 40 microns.

**Patentansprüche**

1. Verfahren zum Ausbilden einer dünnen, dichten, gesinterten Schicht auf einem Substrat, bei welchem

(a) wenigstens eine vorläufige Beschichtung, umfassend die Schritte des Aufbringens einer Paste, umfassend ein sinterförmiges Material in Pulverform, welches in einem organischen Medium dispergiert ist, mittels einer Siebdrucktechnik auf das Substrat aufgebracht und die aufgebrachte Paste getrocknet und calciniert oder gesintert wird und

(b) eine abschließende Beschichtungsbehandlung, umfassend die Schritte des Aufbringens einer Paste, umfassend das sinterfähige Material in Pulverform, welches in einem organischen Medium dispergiert ist, auf das beschichtete Substrat mit Hilfe einer Siebdrucktechnik aufgebracht und die beschichtete Paste unter Sinterbedingungen getrocknet und gesintert wird, dadurch gekennzeichnet, daß die Calcinations- oder Sintertemperatur bei der wenigstens einen vorläufigen Beschichtung das 0,4 bis 0,8-fache der Sintertemperatur der abschließenden Beschichtungsbehandlung währt und daß das bei der abschließenden Beschichtung benutzte Pulver eine Teilchengröße aufweist, welche nicht mehr als das 0,9-fache der Pulvergröße beträgt, die bei dem wenigstens einen vorläufigen Beschichtungsvorgang benutzt wird.

2. Verfahren nach Anspruch 1, dadurch gekennzeichnet, daß die vorläufige Beschichtung zweimal durchgeführt wird.

3. Verfahren nach Anspruch 2, dadurch gekennzeichnet, daß als Paste eine Paste aus einem isolierenden Tonerde-Material verwendet wird.

4. Verfahren nach Anspruch 2, dadurch gekennzeichnet, daß als Paste eine Glaspaste verwendet wird.

5. Verfahren zum Ausbilden einer Schicht aus einem festen, für Sauerstoff-Ionen leitenden Elektrolyten auf einem isolierenden Substrat, bei welchem

(a) wenigstens ein vorläufiger Beschichtungsvorgang vorgenommen wird, umfassend die Schritte

8

des Auftragens einer Paste, umfassend einen festen, für Sauerstoff-Ionen leitenden Elektrolyten in Pulverform, der in einem organischen Medium dispergiert ist, auf das Substrat mit Hilfe einer Siebdrucktechnik aufgetragen wird und die aufgetragene Paste getrocknet und calciniert oder gesintert wird, und

(b) einen abschließenden Beschichtungsvorgang, umfassend die Schritte des Aufbringens einer Paste, umfassend den festen, für Sauerstoff-Ionen leitenden Elektrolyten in Pulverform, welcher dispergiert ist in einem organischen Medium, auf das beschichtete Substrat mit Hilfe einer Siebdrucktechnik aufgetragen und die aufgetragene Paste unter Sinterbedingungen getrocknet und gesintert wird,

dadurch gekennzeichnet, daß das Sintern bei dem abschließenden Vorgang bei einer Temperatur von 800 bis 1500°C ausgeführt wird und daß das Calcinieren oder Sintern bei dem wenigstens einen vorläufigen Beschichtungsvorgang bei einer Temperatur vorgenommen wird, welche das 0,4 bis 0,8-fache der Sintertemperatur des abschließenden Beschichtungsvorganges beträgt, und daß der bei der abschließenden Beschichtung verwendete pulverförmige feste Elektrolyt eine mittlere Teilchengröße aufweist, welche nicht größer ist als das 0,9-fache der Teilchengröße des bei dem wenigstens einen vorläufigen Beschichtungsvorgang verwendeten pulverförmigen festen Elektrolyten.

6. Verfahren nach Anspruch 5, dadurch gekennzeichnet, daß das vorläufige Beschichten zweimal durchgeführt wird.

7. Verfahren nach Anspruch 6, dadurch gekennzeichnet, daß das Calcinieren oder Sintern bei der vorläufigen Beschichtung bei einer Temperatur von 570 bis 1140°C erfolgt und daß das Sintern bei der abschließenden Beschichtungsbehandlung bei einer Temperatur von etwa 1420°C erfolgt.

8. Verfahren nach einem der Patentansprüche 5 bis 7, dadurch gekennzeichnet, daß der pulverförmige feste Elektrolyt eine mittlere Teilchengröße von 0,5 bis 8 $\mu$m aufweist, wobei die maximale Größe nicht mehr als 40 $\mu$m beträgt.

**Revendications**

1. Procédé de formation d'une couche dense mince et frittée sur un substrat comprenant:

(a) une ou plusieurs opérations préliminaires de revêtement comprenant les étapes d'appliquer une pâte, comprenant un matériau frittable sous forme pulvérulente en dispersion dans un véhicule organique, sur le substrat par une technique d'impression à l'écran, et de sécher et de calciner ou de fritter la pâte enduite; et

(b) une opération finale de revêtement comprenant les étapes d'appliquer une pâte, comprenant le matériau frittable sous une forme pulvérulente en dispersion dans un véhicule organique, sur le substrat enduit par une technique d'impression à l'écran et de sécher et de fritter la pâte enduite en conditions de frittage;

caractérisé en ce que la température de calcination ou de frittage dans la ou les opérations préliminaires de revêtement est comprise entre 0,4 et 0,8 fois la température de frittage dans l'opération finale de revêtement et en ce que la poudre employée dans l'opération finale de revêtement a une dimension de particules ne représentant pas plus de 0,9 fois celle de la poudre employée dans la ou les opérations préliminaires de revêtement.

2. Procédé selon la revendication 1, caractérisé en ce que l'opération préliminaire de revêtement est effectuée deux fois.

3. Procédé selon la revendication 2, caractérisé en ce que la pâte est une pâte d'un matériau isolant d'alumine.

4. Procédé selon la revendication 2, caractérisé en ce que la pâte est une pâte de verre.

5. Procédé de formation d'une couche d'un électrolyte solide conducteur de l'ion oxygène sur un substrat isolant comprenant:

(a) une ou plusieurs opérations préliminaires de revêtement comprenant les étapes d'appliquer une pâte, comprenant un électrolyte solide conducteur de l'ion oxygène sous forme pulvérulente en dispersion dans un véhicule organique, sur le substrat, par une technique d'impression à l'écran, et de sécher et de calciner ou de fritter la pâte enduite; et

(b) une opération finale de revêtement comprenant les étapes d'appliquer une pâte, comprenant l'électrolyte solide conducteur de l'ion oxygène sous forme pulvérulente en dispersion dans un véhicule organique, sur le substrat enduit, par une technique d'impression à l'écran et de sécher et fritter la pâte appliquée dans des conditions de frittage;

caractérisé en ce que le frittage dans l'opération finale est effectué à une température de 800 à 1500°C et la calcination ou le frittage dans la ou les opérations préliminaires de revêtement est effectué à une température de 0,4 à 0,8 fois la température de frittage dans l'opération finale de revêtement et l'électrolyte solide pulvérulent employé dans l'opération finale de revêtement a une dimension moyenne ne dépassant pas 0,9 fois celle de l'électrolyte solide pulvérulent employé dans la ou les opérations préliminaires de revêtement.

6. Procédé selon la revendication 5, caractérisé en ce que l'opération préliminaire de revêtement est effectuée deux fois.

7. Procédé selon la revendication 6, caractérisé en ce que la calcination ou le frittage dans l'opération préliminaire de revêtement est effectué à une température de 570 à 1140°C et le frittage dans l'opération finale de revêtement est effectué à une température de l'ordre de 1420°C.

8. Procédé selon l'une quelconque des revendications 5 à 7, caractérisé en ce que l'électrolyte solide pulvérulent a une dimension moyenne de 0,5 à 8 $\mu$ et une dimension maximum ne dépassant pas 40 $\mu$.

# FIG. 1

# FIG. 2

# FIG. 3

# FIG. 4